# EUROPEAN PATENT SPECIFICATION

(11) **EP 2 458 632 B1**
(45) Date of publication and mention of the grant of the patent: **31.07.2013**
(21) Application number: 10425359.6
(22) Date of filing: 24.11.2010
(51) Int. Cl.: H01L 23/40

(54) **Heat sink module for electronic semiconductor devices**
Wärmesenkenmodul für elektronische Halbleitervorrichtungen
Module de dissipateur pour dispositifs de semi-conducteurs électroniques

(43) Date of publication of application: 30.05.2012
(73) Proprietor: Gefran S.p.A., 25050 Provaglio d'Iseo (Brescia) (IT)
(72) Inventor: Santus, Stefano, I-20151 Milano (IT); Molteni, Roberto, 21049 Tradate, Varese (IT)
(74) Representative: Mozzi, Matteo

(56) References cited:
- EP-A2- 1 544 915
- DE-U1- 8 510 248
- US-A- 4 169 642
- US-A- 5 014 161
- US-A- 5 648 889
- US-A- 5 648 893
- US-A1- 2009 205 197

## Description

### Field of application

The object of the present invention is a heat sink module for integrated electronic semiconductor devices, for example electronic power devices.

### Background art

Nowadays, electronic power semiconductor devices are widely used in multiple equipments, such as for example in drive devices for electrical motors, in Power Supply Units or PSU, or in Switch Mode Power Supplies or SMPS. For each of such uses it is necessary to ensure the removal of the heat generated by the semiconductor devices for preventing the overheating of the same which would cause failure, stopping or even break-up thereof.

To this end, power devices are associated to suitable heat sinks usually having a dissipating body configured with fins for increasing the efficiency in heat removal and they are made of copper or aluminium.

For example, a heat sink of the known type for integrated electronic devices comprises a main single block structure that includes the electronic devices. Such single block structure is fixed to an aluminium dissipating body for heat dispersion. In particular, power devices are integrated within the single-block structure for ensuring a high integration of the devices in a limited space.

In such known heat sink, however, once the single block structure has been made, it is not possible anymore to recognise the single electronic devices nor can they be removed from the structure. Thus, in the event of a failure or fault of any device, the latter cannot be repaired.

US5648893 relates to the field of removab!y packaging one or more semiconductor package into a single module.

### Summary of the invention

The object of the present invention is to devise and provide a heat sink for electronic semiconductor devices, for example power devices, which should allow at least partly obviating the drawbacks mentioned above with reference to the known solutions. In particular, the object of the invention is to provide a new heat sink which should ensure the replaceability of such devices in the event of faults and which should at the same time be configurable based on the integrated electronic devices available on the market.

Such object is achieved by a heat sink module according to claim 1.

Preferred embodiments of such heat sink module are defined by the dependent claims 2-12.

The object of the present invention is also a printed circuit comprising the heat sink module of the invention as defined by claim 13.

### Brief description of the drawings

Further features and advantages of the heat sink module according to the invention will appear more clearly from the following description of preferred embodiments thereof, given by way of a non-limiting example with reference to the annexed figures, wherein:
- **figure 1** shows an exploded perspective view of a heat sink module for electronic semiconductor devices according to the invention;
- **figure 2** shows a perspective view of the heat sink module of figure 1 in assembled configuration;
- **figure 3** shows an enlarged view of a cross section of the heat sink module of figure 2;
- **figure 4** and **5** show perspective bottom and top views, respectively, of a printed circuit whereto two heat sink modules of figure 2 are fixed.

### Detailed description

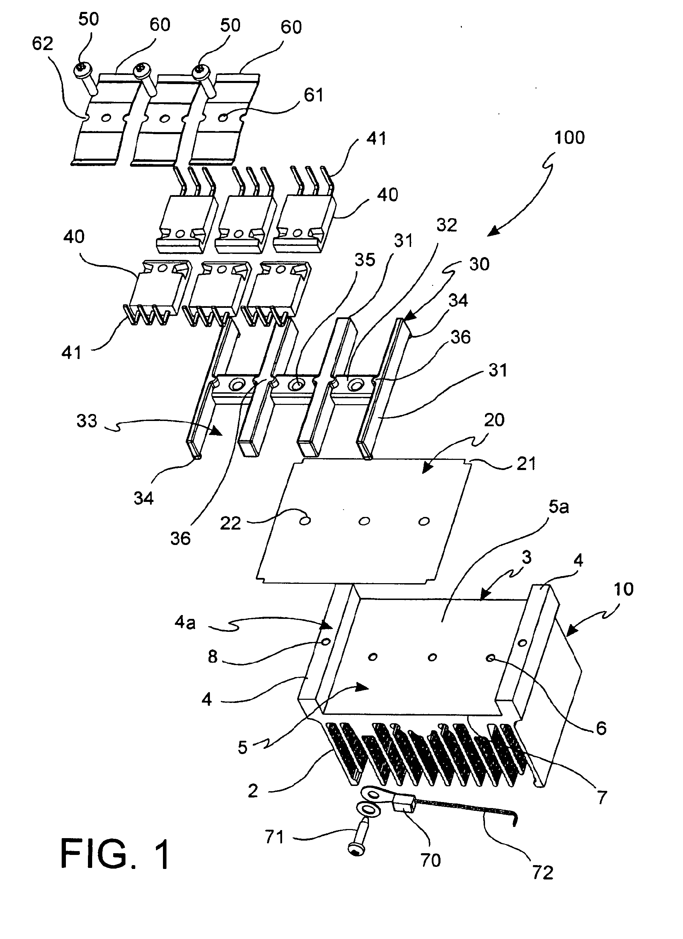

With reference to the above figures 1-3, reference numeral 100 globally denotes a heat sink module for electronic semiconductor devices 40 of the invention. Such electronic devices 40 are, for example, power devices of the known type, but the present invention is also applicable to other types of electronic semiconductor devices. The heat sink module 100 ensures the dissipation of the heat generated during the operation of the above electronic devices for preventing the overheating and consequent failure thereof.

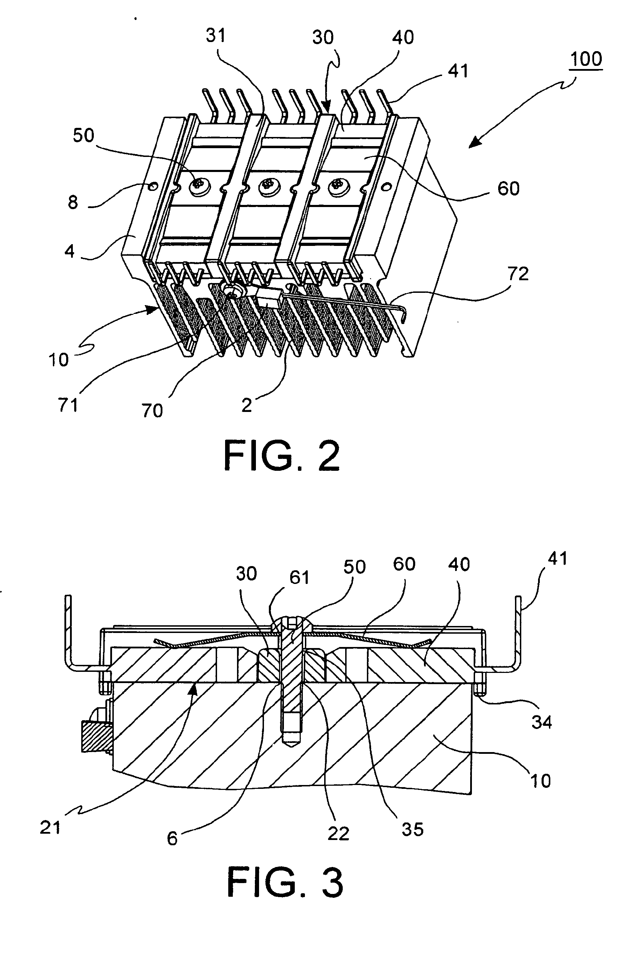

Figure 2 shows, in particular, a view of the heat sink module 100 in assembled configuration and upturned position. Figure 1 shows an exploded view of the heat sink module 100 of figure 2 suitable for highlighting the elements making up the same module.

With reference to the above mentioned figure 1, the heat sink module 100 comprises a dissipating body 10 provided with a plurality of fins 2 suitable for enhancing the removal of the heat developed during the operation of the electronic devices 40.

It should be noted that the dissipating body 10 is made by extrusion of a metal material, for example aluminium. In some applications, for example if an increase of the efficiency of heat sink 100 is desired in heat transfer, the dissipating body 10 may be made of copper.

Such dissipating body 10 comprises a base element 3 made integral with the above fins 2 which substantially extend in a direction orthogonal to the same base element 3.

Moreover, the dissipating body 10 comprises shoulder portions 4 suitable for forming a space 5 with the base element 3 for housing the electronic semiconductor devices 40. Such space 5 comprises a bottom wall 5a substantially having a rectangular shape. Moreover, the shoulder portions 4 protrude orthogonally from the base element 3 in a direction opposite to the fins 2 at smaller sides of the bottom wall 5a of the space.

It should be noted that the larger sides of the rectangular bottom wall 5a of space 5 comprise respective edges 7 devoid of shoulders for favouring the housing of the electronic devices 40 mentioned above.

Seats 6 are obtained on the bottom wall 5a, in particular three seats with a circular cross-section, suitable for receiving respective means for fixing the electronic devices 40 to the heat sink module 100 as shall be explained hereinafter.

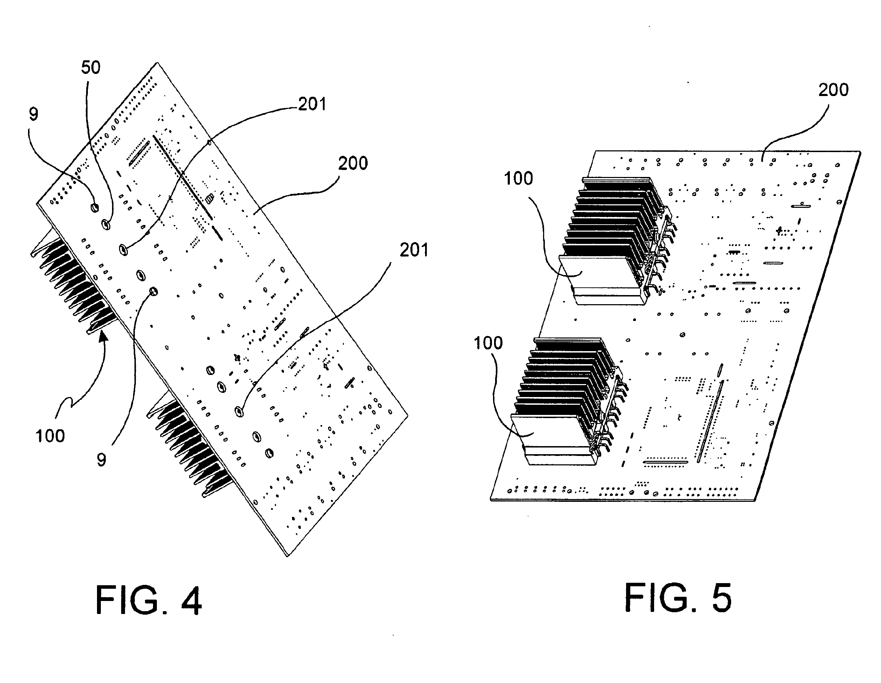

Moreover, the shoulder portions 4 of the dissipating body 10 comprise threaded holes 8 at respective top walls 4a. Such threaded holes 8 are suitable for cooperating with special assembly screws 9 for constraining the heat sink module 100 assembled to a Printed Circuit Board or PCB 200 as shown in figure 4.

In addition, the heat sink module 100 comprises an insulation plate 20 suitable for being positioned on the bottom wall 5a of space 5. Such plate 20 is suitable for ensuring a mutual electrical insulation of the electronic devices 40 housed in the heat sink module 100. In particular, the insulation plate 20 has a substantially rectangular shape and is provided with notches 21 at the rectangle vertices. Moreover, plate 20 comprises at least a first through hole 22, in particular three through holes in the example of figure 1. Each through hole 22 is coaxial to a respective seat 6 of the bottom wall 5a when plate 20 covers such wall. The above insulation plate 20 is made with an insulating material with heat conductive features, for example a thin Polyamide sheet coated with a heat conductive material, for example a silicone- or non-silicone based compound filled with metal oxides. In particular, the heat conductive materials that may be used are KUNZE KU-KG 5 or LOCTITE ISOSTRATE 2000.

Moreover, the heat sink module 100 of the invention comprises means 30, 50, 60 for housing and fixing the above electronic semiconductor devices 40 to the dissipating body 10.

In particular, such housing and fixing means comprise a mounting frame or template 30 suitable for being removably fixed to the dissipating body 10. In particular, the mounting template 30 is fixed to space 5 above the insulating plate 20. Such mounting template 30 is made of an insulating material, for example plastic (Nylon 6,6).

The mounting template 30 comprises at least two bars 31 substantially parallel and connected to one another, at respective median portions, by a crosspiece 32 integral with the same bars 31. In more detail, in the example of figure 1, the mounting template 30 comprises four bars 31 parallel to one another spaced by three crosspieces 32.

The above mounting template 30 positioned in space 5 is suitable for dividing the same space 5 into six slots 33 for as many electronic devices 40.

It should be noted that the number of bars 31 and of the relative crosspieces 32 of template 30 may also be larger than that shown in figure 1.

Moreover, the mounting template 30 advantageously comprises means 34 for aligning the same template 30 to the dissipating body 10 during the assembly of the heat sink module 100. In particular, with reference to figures 1 and 3, such alignment means comprise projecting teeth 34 associated to the outermost bars 31 of the mounting template 30 that in the assembled configuration of figure 2 are adjacent to the shoulder portions 4 of the dissipating body 10. Such teeth 34, in particular, project at distal ends of the outer bars 31 for cooperating, through notches 21 of plate 20, with edges 7 of the bottom wall 5a of space 5 aligning template 30 to the dissipating body 10.

Moreover, each crosspiece 32 of the mounting template 30 comprises a second through hole 35. In this way, with template 30 housed within space 5 above the insulating plate 20, such second hole 35 is coaxial to both one of the first holes 22 of plate 20 and to one of seats 6 obtained on the bottom wall 5a of space 5.

It should be noted that each slot 33 defined by the mounting template 30 in space 5 is advantageously sized for housing a single preformed electronic semiconductor device 40, in particular a power device, which is enclosed in a standard sized enclosure such as, for example, enclosure type T0247.

With reference to figure 2, each electronic device 40 occupies a single slot 33 defined in the heat sink module 100 so that the electrical terminals 41 of device 40 project beyond the same module at edges 7 of the bottom wall 5a.

With reference to figures 1 and 3, the above housing and fixing means further comprise one or more screws 50 for removably fixing the mounting template 30 to the dissipating body 10. Such screws 50 are suitable for cooperating with respective elastic elements 60 for removably fixing the electronic devices 40 to the heat sink module 100. The elastic elements comprise, for example, flat springs 60.

With reference to the example of figure 1, the heat sink module 100 comprises three flat springs 60 and three screws 50. It should be noted, in particular, that each one of such flat springs 60 comprises a respective through hole 61 suitable for being engaged by a screw 50 for concurrently fixing two contiguous electronic devices 40 on the heat sink module 100 separate from one another by the same crosspiece 32.

Moreover, each flat spring 60 comprises centring means 62 of the same spring on the mounting template 30. Such centring means comprise notches 62 obtained on the flat spring 60 suitable for cooperating with corresponding relieves 36 arranged on template 30. The through hole 61 of a flat spring 60 positioned on template 30 is coaxial to the underlying through holes 35 and 22 of template 30 and of the insulating plate 20, respectively.

With reference to figure 3, each screw 50 engages all the above through holes 22, 35 and 61 and is housed in seat 6 obtained in the dissipating body 10 during the fixing of two electronic devices 40.

With reference to figures 1 and 2, the heat sink module 100 of the invention comprises a sensor 70 of the known type connected to the dissipating body 10 by a screw 71. Such sensor 70 is suitable for detecting the temperature of the heat sink module 100 and for sending, through wires 72, corresponding signals to a microprocessor indicative of the temperature value detected. The microprocessor is configured for monitoring the temperature values received so that they do not exceed a predetermined threshold.

The process for assembling the heat sink module 100 of the invention, which allows obtaining the configuration shown in figure 2, shall be described hereinafter by way of an example.

In an initial step, the insulating plate 20 is positioned on the upturned dissipating body 10, in particular on the bottom wall 5a of space 5.

Afterwards, the mounting template 30 is positioned in space 5 above plate 20. In particular, template 30 is aligned with the profile of the bottom wall 5a by the projecting teeth 34.

The preformed electronic devices 40 are positioned in slots 33 defined in space 5 by template 30.

At that point, the flat springs 60 are arranged above template 30 and each pair of devices 40. In particular, each spring 60 is positioned so that the respective notches 62 cooperate with relieves 36 arranged on template 30.

Afterwards, the electronic devices 40 are fixed in pairs to the heat sink module 100 through the fixing screws 50. Each screw 50 engages the through hole 61 of the respective spring 60, the through holes 35 and 22 of template 30 and of plate 20, as well as seat 6 arranged on the bottom wall 5a of the dissipating body 10.

Once the screwing operation has been completed, the assembled heat sink module 100 is upturned and is constrained to the printed circuit PCB 200 by the mounting screws 9 (shown in figure 4) that engage the threaded holes 8 of the dissipating body 10.

Afterwards, with reference to figures 4 and 5, the electrical terminals 41 of the electronic devices 40 are welded to the printed circuit PCB 200. In particular, the welding methods that may be used, known by a man skilled in the art, are wave welding or point-to-point welding. The welding operations may be carried out either manually or automatically.

With reference to figure 4, the printed circuit 200 includes respective through holes 201 for accessing the fixing screws 50 of the heat sink module 100 when the latter is constrained to the printed circuit PCB 200.

In the event of break-up or failure of one or more electronic devices 40 comprised in the heat sink module 100, the procedure is as follows.

The three screws 50 fixing devices 40 to module 100 are unscrewed by acting on the respective holes 201 of the printed circuit 200. Moreover, the screws 9 for mounting the dissipating body 10 to the printed circuit 200 are unscrewed.

The following is removed from the printed circuit 200 in the order: the dissipating body 10, the insulating plate 20 and the mounting template 30. The electronic devices 40 remain constrained to the PCB 200 since the respective terminals 41 are welded to the same circuit.

The faulty electronic device 40 is unwelded and replaced with a new, working device.

The following is replaced on the printed circuit 200 in the order: the mounting template 30, the insulating plate 20, and the dissipating body 10.

At this point, both the three fixing screws 50 and the mounting screws 9 are screwed again for constraining the heat sink module 100 to the printed circuit 200.

Once such operation has been completed, the electrical terminals of the new working electronic device 40 are welded to the printed circuit 200.

The heat sink module 100 for electronic devices described above exhibits several advantages.

In the first place, unlike the solutions with single block structure, the heat sink module 100 ensures complete replaceability of each electronic device 40 in the event of a failure. In this way, the solution proposed is economically advantageous over the known ones. Moreover, the maintenance works on the printed circuit 200 for replacing a faulty electronic device 40 are simple and quick.

Moreover, the structure of the heat sink module 100 may be adjusted to the size, to the electrical and pin-out features of the integrated electronic devices 40 available on the market. The heat sink module 100 therefore is perfectly configurable.

In addition, the mounting template 30 ensures that the electronic devices 40 do not move while mounting the assembly, facilitating the assembly of module 100.

The assembly of the heat sink module 100 may also be carried out in an automated manner for ensuring large volumes of end product at a low cost.

Finally, the insulating plate 20 and the mounting template 30 ensure an adequate insulation of the electronic devices 40. In this way it is not necessary to resort to particular insulated semiconductor devices.

## Claims

1. Heat sink module (100) for electronic semiconductor devices (40), comprising:
- a dissipating body (10) with fins (2) operating for removing the heat developed by said electronic devices (40),
- means (20, 30, 50, 60) for housing and fixing said electronic semiconductor devices (40) to the dissipating body (10),
said housing and fixing means (30, 50, 60) comprising a frame (30) removably fixed to the dissipating body (10), said frame (30) comprising at least two substantially parallel bars (31) connected to each other by a respective crosspiece (32) for defining at least two independent slots (33) with said body for housing said electronic devices, each one of said at least two slots being occupied by a single electronic device removable from the slot,
**characterized in that**
said housing and fixing means (30, 50, 60) comprises at least one fixing screw (50) suitable for cooperating with a respective flat spring (60) for fixing two electronic devices (40) to the module at the same time, said flat spring (60) comprises centring means (62, 36) of the spring on the frame (30),
said centring means comprises notches (62) obtained on the flat spring (60) suitable for cooperating with corresponding relieves (36) arranged on the frame (30).

2. Heat sink module (100) according to claim 1, wherein said frame (30) comprises means (34) for aligning the frame to a base wall (5a) of the dissipating body (10).

3. Heat sink module (100) according to claim 2, wherein said alignment means comprise projecting teeth (34) associated to said at least two bars (31) at opposite ends of the bars distal from the crosspiece (32).

4. Heat sink module (100) according to claim 1, wherein said at least one fixing screw (50) is suitable for engaging a first through hole (62) arranged on the flat spring (60), a second through hole (35) arranged on the crosspiece (32) and for being seated in at least one seat (6) of the dissipating body (10).

5. Heat sink module (100) according to claim 2, further comprising an insulating plate (20) interposed between said frame (30) and the base wall (5a) of the dissipating body (10).

6. Heat sink module (100) according to claim 5, wherein said dissipating body (10) comprises a space (5) delimited by the base wall (5a) and by shoulder elements (4) projecting orthogonally from the above base wall (5a) in a direction opposite the fins (2), said space (5) being configured for housing the insulating plate (20) and the frame (30).

7. Heat sink module (100) according to claim 6, wherein each shoulder element (4) comprises a threaded hole (8) suitable for cooperating with a respective mounting screw (9) for constraining the heat sink module to a printed circuit (200).

8. Heat sink module (100) according to claim 5, wherein said insulating plate (20) comprises at least a respective third through hole (22) coaxial to said first through hole (62) of the flat spring (60), with said second through hole (35) of the frame (30) and with said at least one seat (6) obtained in the base wall (5a) of the dissipating body (10).

9. Printed circuit (200) comprising at least one heat sink module (100) for electronic semiconductor devices (40), as defined by claims 1-8.

## Patentansprüche

1. Kühlkörpermodul (100) für elektronische Halbleitervorrichtungen (40), umfassend:
- einen Ableitkörper (10) mit Rippen (2), um im Betrieb die von den elektronischen Vorrichtungen (40) erzeugte Wärme zu beseitigen,
- ein Mittel (20, 30, 50, 60) zum Aufnehmen und Fixieren der elektronischen Halbleitervorrichtungen (40) an dem Ableitkörper (10);
wobei das Aufnahme- und Befestigungsmittel (30, 50, 60) einen Rahmen (30) aufweist, der an dem Ableitkörper (10) entfernbar befestigt ist, wobei der Rahmen (30) zumindest zwei im Wesentlichen parallele Stäbe (31) aufweist, die durch ein jeweiliges Querstück (32) miteinander verbunden sind, um zumindest zwei unabhängige Schlitze (33) mit dem Körper zur Aufnahme der elektronischen Vorrichtungen zu definieren, wobei ein jeder der zumindest zwei Schlitze durch eine aus dem Schlitz entfernbare einzelne elektronische Vorrichtung belegt ist,
**dadurch gekennzeichnet, dass** das Aufnahme und Befestigungsmittel (30, 50, 60) zumindest eine Befestigungsschraube (50) aufweist, die geeignet ist, um mit einer jeweiligen Blattfeder (60) zusammenzuwirken, um zwei elektronische Vorrichtungen (40) an dem Modul gleichzeitig zu fixieren, wobei die Blattfeder (60) ein Zentriermittel (62, 36) der Feder auf dem Rahmen (30) aufweist,
wobei das Zentriermittel Kerben (62) aufweist, die an der Blattfeder (60) erhalten sind, geeignet zum Zusammenwirken mit entsprechenden Reliefs (36), die an dem Rahmen (30) angeordnet sind.

2. Kühlkörpermodul (100) nach Anspruch 1, worin der Rahmen (30) ein Mittel (34) aufweist, um den Rahmen zu einer Basiswand (5a) des Ableitkörpers (10) auszurichten.

3. Kühlkörpermodul (100) nach Anspruch 2, worin das Ausrichtmittel an von dem Querstück (32) entfernten entgegengesetzten Enden der Stäbe vorstehende Zähne (34) aufweist, die den zumindest zwei Stäben (31) zugeordnet sind.

4. Kühlkörpermodul (100) nach Anspruch 1, worin die zumindest eine Befestigungsschraube (50) zum Eingriff in ein erstes Durchgangsloch (62), das an der Blattfeder (60) angeordnet ist, ein zweites Durchgangsloch (35), das an dem Querstück (32) angeordnet ist, und zum Sitzen in zumindest einem Sitz (6) des Ableitkörpers (10) geeignet ist.

5. Kühlkörpermodul (100) nach Anspruch 2, das ferner eine Isolierplatte (20) aufweist, die zwischen dem Rahmen (30) und der Basiswand (5a) des Ableitkörpers (10) angeordnet ist.

6. Kühlkörpermodul (100) nach Anspruch 5, worin der Ableitkörper (20) einen Raum (5) aufweist, der durch die Basiswand (5a) und durch Schulterelemente (4) begrenzt ist, die orthogonal von der obigen Basiswand (5a) in Richtung entgegengesetzt der Rippen (2) vorstehen, wobei der Raum (5) konfiguriert ist, um die Isolierplatte (20) und den Rahmen (30) aufzunehmen.

7. Kühlkörpermodul (100) nach Anspruch 6, worin jedes Schulterelement (4) ein Gewindeloch (8) aufweist, das zum Zusammenwirken mit einer jeweiligen Befestigungsschraube (9) geeignet ist, um das Kühlkörpermodul auf einer gedruckten Schaltung (200) zu halten.

8. Kühlkörpermodul (100) nach Anspruch 5, worin die Isolierplatte (20) zumindest ein jeweiliges drittes Durchgangsloch (2) aufweist, das zu dem ersten Durchgangsloch (62) der Blattfeder (60) koaxial ist, mit dem zweiten Durchgangsloch (35) des Rahmens (30) und mit dem in der Basiswand (5a) des Ableitkörpers (10) erhaltenen zumindest einen Sitz (6).

9. Gedruckte Schaltung (200), die zumindest ein Kühlkörpermodul (100) für elektronische Halbleitervorrichtungen (40) aufweist, wie in den Ansprüchen 1 bis 8 definiert.

## Revendications

1. Module de dissipateur thermique (100) pour des dispositifs semi-conducteurs électroniques (40), comportant:
- un corps de dissipation (10) avec des ailettes (2) fonctionnant pour supprimer la chaleur développée par lesdits dispositifs électroniques (40),
- des moyens (20, 30, 50, 60) pour contenir et fixer lesdits dispositifs semi-conducteurs électroniques (40) au corps de dissipation (10),
lesdits moyens de logement et de fixation (30, 50, 60) comportant un cadre (30) fixé de façon amovible au corps de dissipation (10), ledit cadre (30) comportant au moins deux barres sensiblement parallèles (31) reliées l'une à l'autre par une entretoise respective (32) pour définir au moins deux fentes indépendantes (33) avec ledit corps pour loger lesdits dispositifs électroniques, chacune desdites au moins deux fentes étant occupée par un dispositif électronique unique amovible de la fente,
**caractérisé en ce que**
lesdits moyens de logement et de fixation (30, 50, 60) comporte au moins une vis de fixation (50) adaptée pour coopérer avec un ressort plat respectif (60) pour fixer deux dispositifs électroniques (40) au module en même temps, ledit ressort plat (60) comporte un moyen de centrage (62, 36) du ressort sur le cadre (30),
ledit moyen de centrage comporte des encoches (62) obtenues sur le ressort plat (60) adaptées pour coopérer avec des parties saillantes correspondantes (36) disposés sur le cadre (30).

2. Module de dissipateur thermique (100) selon la revendication 1, dans lequel ledit cadre (30) comporte des moyens (34) pour aligner le cadre sur une paroi de base (5a) du corps de dissipation (10).

3. Module de dissipateur thermique (100) selon la revendication 2, dans lequel ledit moyen d'alignement comportent des dents saillantes (34) associées auxdites au moins deux barres (31) aux extrémités opposées des barres distales de l'entretoise (32).

4. Module de dissipateur thermique (100) selon la revendication 1, dans lequel ladite au moins une vis de fixation (50) est adaptée pour s'engager dans un premier trou traversant (62) agencé sur le ressort plat (60), un second trou traversant (35) agencé sur l'entretoise (32) et pour être placé dans au moins un siège (6) du corps de dissipation (10).

5. Module de dissipateur thermique (100) selon la revendication 2, comportant en outre une plaque isolante (20) interposée entre ledit cadre (30) et la paroi de base (5a) du corps de dissipation (10).

6. Module de dissipateur thermique (100) selon la revendication 5, dans lequel ledit corps de dissipation (10) comporte un espace (5) délimité par la paroi de base (5a) et par des éléments d'épaulement (4) faisant saillie orthogonalement depuis la paroi de base précitée (5a) dans une direction opposée aux ailettes (2), ledit espace (5) étant configuré pour loger la plaque isolante (20) et le cadre (30).

7. Module de dissipateur thermique (100) selon la revendication 6, dans lequel chaque élément d'épaulement (4) comporte un trou fileté (8) adapté pour coopérer avec une vis de montage respective (9) pour contraindre le module de dissipateur thermique sur le circuit imprimé (200).

8. Module de dissipateur thermique (100) selon la revendication 5, dans lequel ladite plaque isolante (20) comporte au moins un troisième trou traversant respectif (22) coaxial audit premier trou traversant (62) du ressort plat (60), avec ledit second trou traversant (35) du cadre (30) et avec ledit au moins un siège (6) obtenu dans la paroi de base (5a) du corps de dissipation (10).

9. Circuit imprimé (200) comportant au moins un module de dissipateur thermique (100) pour des dispositifs semi-conducteurs électroniques (40), tel que défini dans les revendications 1-8.
